# EUROPEAN PATENT APPLICATION

(11) **EP 4 726 777 A1**
(43) Date of publication of application: **15.04.2026**
(21) Application number: 24306663.6
(22) Date of filing: 10.10.2024
(51) Int. Cl.: H01L 23/66, H01L 23/00, H03F 1/34

(54) **RADIOFREQUENCY DEVICES WITH NEGATIVE FEEDBACK FIELD PLATES**

(71) Applicant: NXP USA, Inc., Austin, TX 78735 (US)
(72) Inventor: SIMON, Jérémie, 31023 Toulouse (FR)
(74) Representative: Hardingham, Christopher Mark

(57) **Abstract**

A device includes a radiofrequency integrated circuit (RFIC) having a radiofrequency (RF) input terminal and an RF output terminal and also includes a field plate electrode having a first end that is electrically-coupled to the RF output terminal and a second end that is suspended above the RFIC. The second end of the field plate electrode is configured to float at an electric potential that is determined by an electric potential of the RF output terminal.

## Description

### TECHNICAL FIELD

Embodiments of the subject matter described herein relate to semiconductor integrated circuits and methods of fabrication of such circuits.

### BACKGROUND

Semiconductor circuits, including transistor-based circuits, are often used for analog signal processing applications including amplification of radio and microwave-frequency (RFMW) signals and for power-switching. Advanced transistor designs and high-performance materials such as III-V semiconductors have been used to achieve increased power densities while providing acceptable thermal performance and voltage-induced breakdown characteristics. Transistors for high-performance applications are frequently formed from repeating cells each having separate input, output, and control "fingers" which can be electrically interconnected to allow the cells to be operated in parallel as a single transistor.

### SUMMARY

In an example embodiment, device includes a radiofrequency integrated circuit (RFIC) having a radiofrequency (RF) input terminal and an RF output terminal. A field plate electrode having a first end that is electrically-coupled to the RF output terminal and a second end that is suspended above the RFIC and the second end of the field plate electrode is configured to float at an electric potential that is determined by an electric potential of the RF output terminal.

In another example embodiment, a method includes receiving an RF integrated circuit (RFIC) having an RF input terminal and an RF output terminal and; forming a field plate electrode having a first end and a second end. The first end of the field plate electrode is electrically-coupled to the RF output terminal and the second end of the field plate electrode is suspended above the RFIC. The second end of the field plate electrode is configured to float at an electric potential that is determined by an electric potential of the RF output terminal.

### BRIEF DESCRIPTION OF THE SEVERAL VIEWS OF THE DRAWINGS

The present disclosure is illustrated by way of examples, embodiments and the like and is not limited by the accompanying figures, in which like reference numbers indicate similar elements. The figures along with the detailed description are incorporated and form part of the specification and serve to further illustrate examples, embodiments and the like, and explain various principles and advantages, in accordance with the present disclosure, wherein:
FIG. 1A is a schematic cross-sectional view plan view of an example integrated circuit according to one or more embodiments.
FIG. 1B is a schematic plan view of the integrated circuit of FIG. 1A.
FIG. 2 is a schematic cross-sectional view plan view of another example integrated circuit according to one or more embodiments.
FIG. 3 is a schematic cross-sectional view plan view of another example integrated circuit according to one or more embodiments.

### DETAILED DESCRIPTION

The following detailed description provides examples for the purposes of understanding and is not intended to limit embodiments of this Disclosure and uses of the same. Furthermore, there is no intention to be bound by any expressed or implied theory presented in the preceding technical field, background, or the detailed description.

For simplicity and clarity of illustration, elements in the Drawings are not necessarily drawn to scale. For example, the dimensions of some of the elements or regions in the figures may be exaggerated relative to other elements or regions to help improve understanding of embodiments of the invention. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

It will be understood that references to particular transistor structures (e.g., "source" and "drain") are for purposes of illustration and are intended as nonlimiting examples unless otherwise specified. For instance, it will be understood that the terms source and drain can be interchanged and that features described as forming part of a source terminal can instead form part of a drain terminal. Similarly, it will be understood that references to terminals that are associated with field effect transistors such as "source," "gate," and "drain" can be used to refer to equivalent structures in other types of transistors (e.g., emitter, base, and collector terminals of a bipolar transistor).

Amplifiers and other radiofrequency (RF) devices can sometimes exhibit unpredictable variations in performance due to unwanted RF interference. In some instances, the interference can arise from the device itself in the form of current loops that can arise from uneven voltage distribution across portions of the device. These current loops and the associated oscillating magnetic fields can be amplified in a positive feedback loop that results in amplifier oscillations which can manifest as highly nonlinear gain as a function of input power. Because such feedback effects can be hard to predict, it is desirable for amplifiers and related RF devices to include structures that suppress unwanted oscillations. Accordingly, devices according to embodiments herein include one or more electrodes configured to suppress unwanted oscillations as described further below.

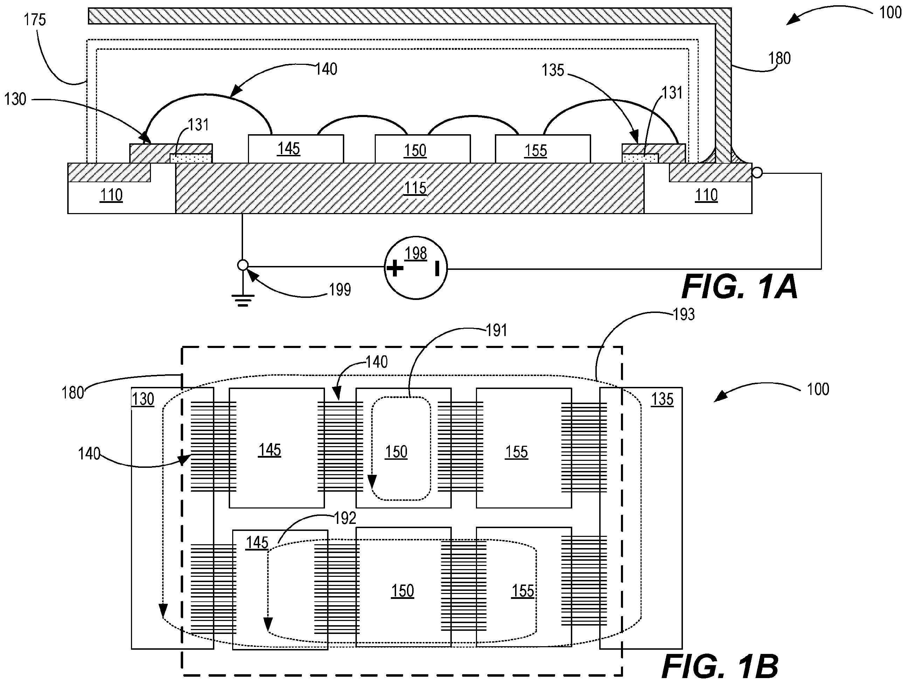

FIG. 1A is a schematic cross-sectional view of an example RF device integrated circuit (IC) according to one or more embodiments. The IC 100 includes a substrate 110 (e.g., a printed circuit board or other suitable carrier substrate) with a metallic flange 115 which can be used as an electrical ground (e.g., the flange 115 can be coupled to a reference voltage node 199) and as a heatsink. The IC 100 has a first terminal 130 and a second terminal 135. The input terminal 130 is electrically coupled to an input node of an amplifier die 150 via matching circuitry 145 which can reside on a separate die, as shown. The input terminal 130 and the output terminal 135 can be isolated from the metallic flange 115 by electrically insulating stand-offs 131. The output terminal 135 is electrically coupled to an output node of the amplifier die 150 via matching circuitry 155 which can reside on a separate die, as shown. The various components can be interconnected by bond wires 140, as shown. The first terminal 130 and the second terminal 135 can be coupled to any appropriate portions of the IC 100. In this example, the first terminal 130 can be coupled to a gate or other control terminal of one or more transistors on the die 150 and the second terminal 135 can be electrically coupled, via the matching circuitry 155, to an output of the IC 100 such as a drain terminal of an amplifier on the die 150 which can be coupled to voltage source 198 (e.g., a drain voltage supply).

The IC 100 can be enclosed by a cover 175 which may be positioned over the IC 100 as shown or in any other suitable arrangement. In one or more embodiments, a cover such as the cover 175 is part of a larger ceramic or polymer package in which IC 100 is enclosed. A field plate electrode (a field plate 180) is mechanically and electrically connected to an output of the IC 100 and extends above the RF components of the IC 100 (i.e., the die 150 and the matching circuitry 145 and 155). Because the field plate 180 is electrically coupled to an RF output of the die 150 (via the second terminal 135), the field plate 180 will be biased with a time-varying electric potential that is synchronous with the RF output of the IC 100. The resulting RF currents in the field plate 180 can induce currents in the IC 100 (e.g., in the bond wires 140 and other portions of the IC 100) that will tend to counter undesired currents circulating in the IC 100. In other words, a field plate such as the field plate 180 or related structures according to embodiments herein can act as negative feedback elements that can suppress unwanted circulating currents.

FIG 1B is a schematic plan view of the IC 100. In this example, the IC 100 includes two amplifiers in parallel (die 150) with respective matching circuitry 145 coupled between each die 150 and the first terminal 130 by bond wires 140 and respective matching circuitry 155 coupled between each die 150 and the second terminal 135 of the IC 100 by other bond wires 140. The footprint of the field plate 180 above the die 150 and other components is indicated by a dashed line. Unwanted induced currents in the IC 100 can be localized within a single die or other component, as illustrated by the path 191 or induced currents can run through multiple components connected via bond wires 140 as indicated by the dashed loop 192. It is also possible for unwanted currents to circulate between the first terminal 130 and the second terminal 135 as indicated by the dashed loop 193.

It will be appreciated that the IC 100 is an illustrative example and that embodiments disclosed herein are not limited to amplifier circuits or to circuits arranged as shown in the Figures. For example, there is no requirement that an integrated circuit according to embodiments herein include any specific number of die or that die and other components be interconnected in any particular manner (e.g., two die can be connected by one or more electrical traces or one or more waveguides rather than by wire bonds such as the bond wires 140). Similarly, a field plate such as the field plate 180 and related structures can have any suitable dimensions and are not limited to a specific footprint such as the footprint of the field plate 180 as shown in FIG. 1A and FIG. 1B.

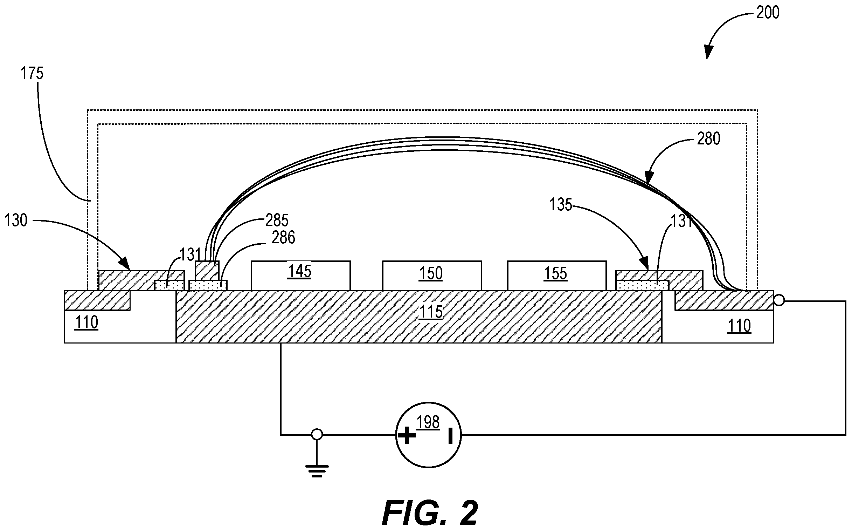

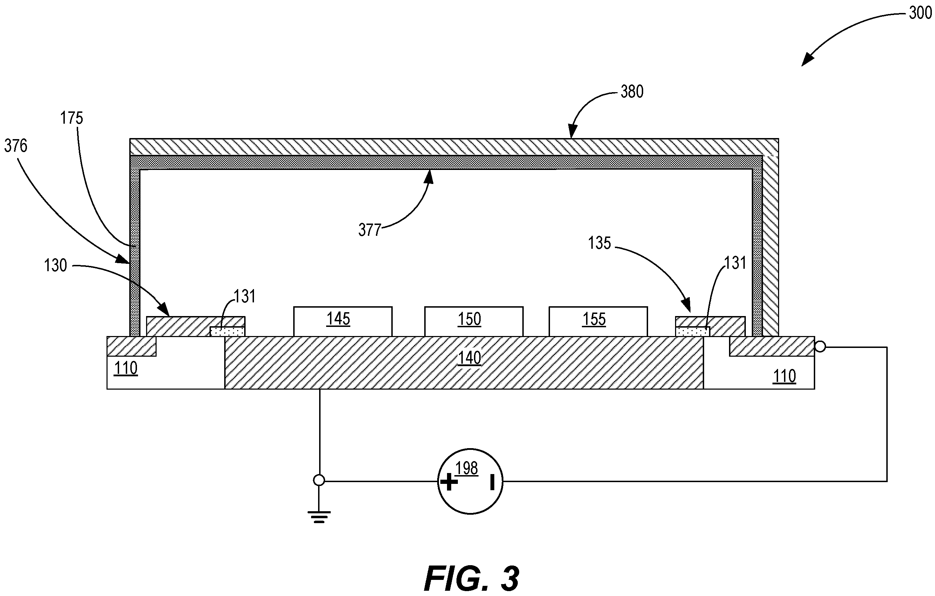

FIG. 2 is a schematic cross-sectional view of another example integrated circuit that is related to the IC 100 of FIG. 1A and FIG. 1B. In the IC 200, the field plate 180 has been replaced by one or more bond wires 280 that act as a field plate, Each of these bond wires 280 is coupled at one end to the second terminal 135 and to an electrically-isolated bond pad 285 at the other end (e.g., disposed as shown on an electrically-insulating stand-off 286). The IC 200, including the bond wires 280 can be disposed within a cover such as the cover 175 or within any other suitable package structure. For simplicity, bond wires 140 are not shown in FIG. 2 or FIG. 3.

FIG. 3 is a schematic cross-sectional view of another example integrated circuit that is related to the IC 100 of FIG. 1A and FIG. 1B and the IC 200 of FIG. 2. In one or more embodiments, a field plate such as the field plate 380 is formed on an exterior surface of a lid, cover, or related structure such as the exterior surface 376 of the cover 175 as shown in FIG. 3. In one or more embodiments, a field plate is formed on an interior surface of such a package structure (e.g., on the interior surface 377 of the cover 175 shown in FIG. 3). In one or more embodiments, a field plate is integrally formed within a package structure such as the cover 175. For example, a field plate such as the field plate 180 or 380 can be encapsulated within a volume of molding material that forms the cover 175.

### EXAMPLES

Features of embodiments may be understood by way of one or more of the following examples:
Example 1: A device or method that includes An RF integrated circuit (RFIC) having an RF input terminal and an RF output terminal and a field plate electrode having a first end that is electrically-coupled to the RF output terminal and a second end that is suspended above the RFIC. The second end of the field plate electrode is configured to float at an electric potential that is determined by an electric potential of the RF output terminal.
Example 2: The device or method of Example 1 where the RFIC is enclosed within a nonmetallic device package and the second end of the field plate electrode is disposed above a top exterior surface of the device package.
Example 3: The device or method of Example 1 or Example 2, where the first end of the field plate electrode is coupled to a portion of the RF output terminal that is exposed at an exterior of the device package.
Example 4: The device or method of any one of Examples 1-3, where at least the second end of the field plate electrode is encapsulated within molding material forming a portion of the nonmetallic device package that is disposed above the RFIC.
Example 5: The device or method of any one of Examples 1-4, where the second end of the field plate electrode is disposed in direct contact with a top exterior surface of a device package enclosing the RFIC.
Example 6: The device or method of any one of Examples 1-5, where the second end of the field plate electrode is suspended above a top exterior surface of a nonmetallic device package that encloses the RFIC
Example 7: The device or method of any one of Examples 1-6, where the field plate electrode is formed by one or more wire bonds having first ends electrically-coupled to the RF output terminal and second ends bonded to a bond pad that is electrically isolated from the RFIC by an electrically-insulating material.
Example 8: The device or method of any one of Examples 1-7, where the second ends of the one or more wire bonds are capacitively coupled to the RF input terminal.
Example 9: The device or method of any one of Examples 1-8, where the field plate electrode is configured to operate as negative feedback element that is electrically coupled between the RF output terminal and the RF input terminal.
Example 10: The device or method of any one of Examples 1-9 where the RFIC is enclosed within a device package and where the second end of the field plate electrode is disposed on an interior surface of the device package above the RFIC.

The preceding Description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Figures.

The connecting lines shown in the various figures contained herein are intended to represent exemplary functional relationships and/or physical couplings between the various elements. It should be noted that many alternative or additional functional relationships or physical connections may be present in one or more embodiments of the Disclosure.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description. It is to be understood that other phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. Herein, "A, B, and/or C" is defined as "A or B or C" or any combination of A, B, or C.

As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations of the figures may depict exemplary arrangements of elements, additional intervening elements, devices, features, or components may be present in one or more embodiments of the depicted subject matter.

The terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that numerical terms used herein are interchangeable under appropriate circumstances such that the embodiments of the invention described herein are, for example, capable of operation in sequences other than those illustrated or otherwise described herein.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A device comprising:
an RF integrated circuit, RFIC, having a radiofrequency, RF, input terminal and an RF output terminal; and
a field plate electrode having a first end that is electrically-coupled to the RF output terminal and a second end that is suspended above the RFIC;
wherein the second end of the field plate electrode is configured to float at an electric potential that is determined by an electric potential of the RF output terminal.

2. The RF device of Claim 1:
wherein the RFIC is enclosed within a nonmetallic device package; and
wherein the second end of the field plate electrode is disposed above a top exterior surface of the device package.

3. The device of Claim 2, wherein the first end of the field plate electrode is coupled to a portion of the RF output terminal that is exposed at an exterior of the device package.

4. The device of Claim 2 or 3, wherein at least the second end of the field plate electrode is encapsulated within molding material forming a portion of the nonmetallic device package that is disposed above the RFIC.

5. The device of any of Claims 2 to 4, wherein the second end of the field plate electrode is disposed in direct contact with the top exterior surface of the device package.

6. The device of any of Claims 2 to 4, wherein the second end of the field plate electrode is suspended above the top exterior surface of the device package.

7. The device of any preceding Claim, wherein the field plate electrode is formed by one or more wire bonds having first ends electrically-coupled to the RF output terminal and second ends bonded to a bond pad that is electrically isolated from the RFIC by an electrically-insulating material.

8. The device of Claim 7, wherein the second ends of the one or more wire bonds are capacitively coupled to the RF input terminal.

9. The RF device of any preceding Claim, wherein the field plate electrode is configured to operate as negative feedback element that is electrically coupled between the RF output terminal and the RF input terminal.

10. The device of any preceding Claim:
wherein the RFIC is enclosed within a device package; and
wherein the second end of the field plate electrode is disposed on an interior surface of the device package above the RFIC.

11. A method comprising:
receiving an RF integrated circuit, RFIC, having a radiofrequency, RF, input terminal and an RF output terminal; and
forming a field plate electrode having a first end that is electrically-coupled to the RF output terminal and a second end that is suspended above the RFIC;
wherein the second end of the field plate electrode is configured to float at an electric potential that is determined by an electric potential of the RF output terminal.

12. The method of Claim 11, further comprising enclosing the RFIC within a nonmetallic device package;
wherein the second end of the field plate electrode is disposed above a top exterior surface of the device package.

13. The method of Claim 12, wherein the first end of the field plate electrode is coupled to a portion of the RF output terminal that is exposed at an exterior of the device package.

14. The method of Claim 12 or 13, further comprising encapsulating at least the second end of the field plate electrode is within molding material forming a portion of the nonmetallic device package that is disposed above the RFIC.

15. The method of any of Claims 12 to 14, wherein the second end of the field plate electrode is disposed in direct contact with the top exterior surface of the device package.
